# EUROPEAN PATENT SPECIFICATION

(11) **EP 3 335 244 B1**
(45) Date of publication and mention of the grant of the patent: **12.08.2020**
(21) Application number: 16835955.2
(22) Date of filing: 12.08.2016
(51) Int. Cl.: H01L 31/02, H01L 31/05, H01L 31/0224

(54) **PHOTOVOLTAIC CELL WITH FRONTSIDE BUSBAR TAPE ON NARROW FRONT BUSBARS**
FOTOVOLTAIKZELLE MIT FRONTSEITIGEM SAMMELSCHIENENBAND AUF SCHMALEN FRONTSAMMELSCHIENEN
CELLULE PHOTOVOLTAÏQUE AVEC UNE BANDE DE BARRES OMNIBUS DE CÔTÉ AVANT SUR DES BARRES OMNIBUS AVANT ÉTROITES

(30) Priority: 13.08.2015 US 201562204476 P
(43) Date of publication of application: 20.06.2018
(73) Proprietor: 3M Innovative Properties Company, St. Paul, MN 55133-3427 (US)
(72) Inventor: ROTTO, Nelson T., Saint Paul, MN 55133-3427 (US)
(74) Representative: Mathys & Squire
(86) International application number: PCT/US2016/046677
(87) International publication number: WO 2017/027769

(56) References cited:
- EP-A1- 2 590 226
- WO-A1-2014/149714
- US-A1- 2011 023 952
- US-A1- 2011 048 492
- US-A1- 2011 247 688
- US-A1- 2011 315 184

## Description

The present disclosure relates to photovoltaic ("PV") solar cell comprising a frontside busbar tape in electrical contact with narrow front busbars (e.g., silver busbars). A single frontside busbar tape may be in electrical contact with a single narrow front busbar or with a dual set of narrow front busbars. The disclosure also relates to modified gridlines and methods of enhancing the electrical connection between gridlines and narrow busbars and busbar tape on a solar PV cell.

### Background

Renewable energy is energy derived from natural resources that can be replenished, such as sunlight, wind, rain, tides, and geothermal heat. The demand for renewable energy has grown substantially with advances in technology and increases in global population. Although fossil fuels provide for the vast majority of energy consumption today, these fuels are non-renewable. The global dependence on these fossil fuels has not only raised concerns about their depletion but also environmental concerns associated with emissions that result from burning these fuels. As a result of these concerns, countries worldwide have been establishing initiatives to develop both large-scale and small-scale renewable energy resources.

One of the promising energy resources today is sunlight. Globally, millions of households currently obtain power from solar energy generation. The rising demand for solar power has been accompanied by a rising demand for devices and materials capable of fulfilling the requirements for these applications. Solar cells and photovoltaic modules are a fast-growing segment of solar power generation.

Photovoltaic modules convert energy emitted by the sun into electricity. Many photovoltaic modules have a transparent material (e.g., a sheet of glass) on the front (i.e., facing the sun) side. Sunlight passes through the transparent material and is incident on the solar cells. The photons in the sunlight are absorbed by one or more semiconducting material(s) (e.g., multi or mono crystalline silicon) in the solar cells. As photons are absorbed, electrons are knocked loose from their atoms, creating an electric potential difference. The electrons move via diffusion from a region of high electron concentration (the n-type side of the junction) to a region of low electron concentration (the p-type side of the junction), thereby causing current to flow through the semiconductive material. The rear surface of the photovoltaic module typically includes a conductive aluminum material (e.g., fired paste), which acts as an excellent p-type side of the junction.

### Summary

The inventor of the present disclosure recognized that elimination or reduction of the front and rear silver busbars on solar cells and solar modules would advantageously lower the total cost of the solar cell and /or solar module. The typical silver busbars (e.g., silver paste) on the front and rear surface of solar cells or solar modules can be reduced in size (e.g., to the width comparable to that of a frontside silver finger) and serve as a substrate for a solderable tape including a conductive metal foil and a nonconductive adhesive. In one embodiment, a single narrow busbar is used to serve as substrate for a single frontside busbar tape. In another embodiment, dual busbars are used to serve as substrate for a single frontside busbar tape. The inventor of the present disclosure also recognized that a tape including a conductive metal foil and a nonconductive adhesive can be applied to the front and rear surface of a solar cell or solar module to provide an electrically conductive surface to which a stringing ribbon can be soldered. After the reduction in size of the silver busbars on solar cells, the fine gridlines (or fingers) on the frontside are the only additional remaining structure on the solar cell that utilizes expensive silver paste.

The inventor of the present disclosure further recognized that when bonding busbar tape directly to the front fingers/gridlines of the solar cell, the electrical connection between busbar tape and the silver gridlines may be sufficient to conduct electricity and produce a working PV cell. However, in certain applications, the strength and quality of the electrical connection between busbar tape and the silver gridlines may need to be improved. PCT Application Publication Nos. WO2014/149714 and WO2014/149715 disclose busbar tapes that can be used in all embodiments of the present disclosure calling for a busbar tape. US2011/048492 discloses a photovoltaic cell with a busbar and a solder coating.

In certain embodiments, a narrow (or "finger-like") front busbar (typically made of silver) which is a continuous structure that typically spans the entire length of the cell, is used. In some embodiments, the narrow busbar has a width of approximately 10-150 microns. The front busbar tape is then bonded to this single narrow front busbar. In another embodiment, the front busbar tape is bonded to a dual set of narrow front busbars. Typically, regular stringing/tabbing ribbon is then soldered to the front busbar tape as part of the cell stringing process.

In general, whether the busbar tape is bonded to a single narrow busbar or to dual busbars, the width of the narrow busbar is from 10 to 150 microns, or from 10 to 140 microns, or from 10 to 130 microns, or from 10 to 120 microns, or from 10 to 110 microns, or from 20 to 140 microns, or from 20 to 130 microns, or from 20 to 120 microns, or from 20 to 110 microns, or from 50 to 140 microns, or from 50 to 130 microns, or from 50 to 120 microns, or from 50 to 110 microns, or from 50 to 100 microns, or from 60 to 130 microns, or from 60 to 120 microns, or from 60 to 110 microns, or from 60 to 100 microns, or from 60 to 90 microns, or from 60 to 80 microns, or from 65 to 75 microns, or approximately 70 microns.

This disclosure describes modified front busbars with narrow widths that serve as a substrate for a busbar tape (either as a single narrow busbar or as dual narrow busbars). This disclosure also describes methods to enhance the electrical bond between a busbar tape and the frontside of the PV cell, which reduces silver paste usage on the frontside of a conventional solar cell, and still provides a reliable and strong connection between the cell and the interconnect ribbon (also referred to in this disclosure as "tabbing ribbon" or "stringing ribbon.")

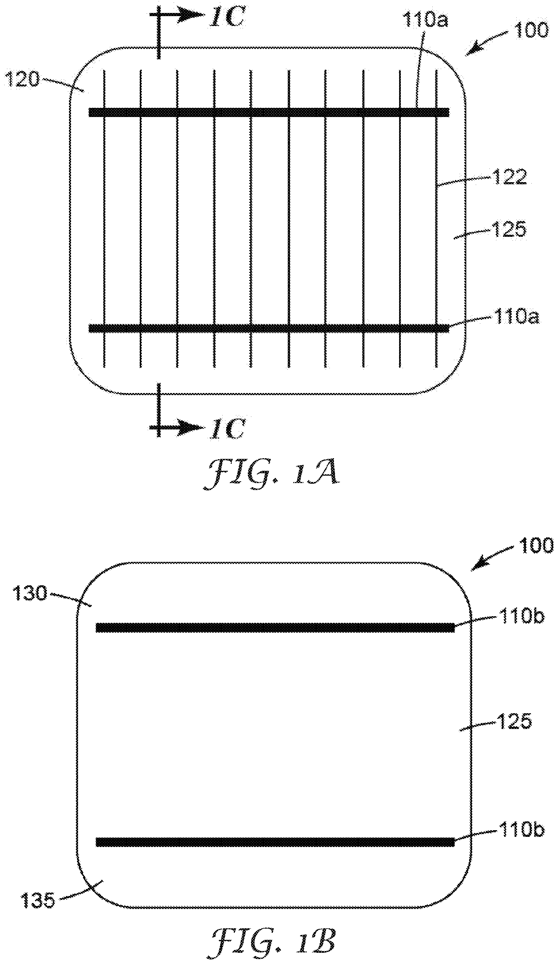

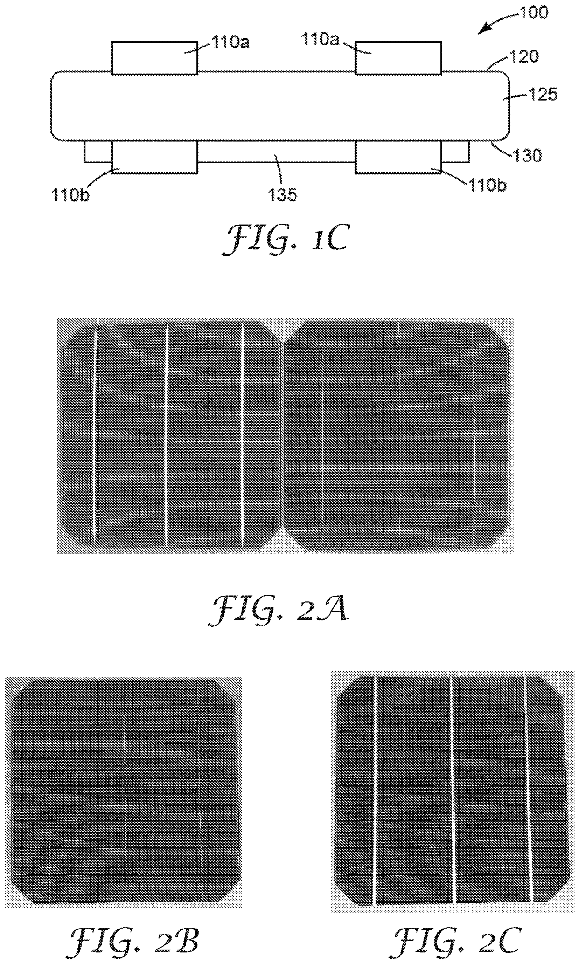

One exemplary photovoltaic cell is shown schematically in Figs. 1A, 1B, and 1C. Figs. 1A and 1B are, respectively, top and bottom schematic views of photovoltaic cell 100. Fig. 1C is a cross-sectional view of photovoltaic cell 100 taken between and parallel to gridlines 122. Photovoltaic cell 100 includes busbars 110a on the front major surface 120 of semiconductor assembly 125 and busbars 110b on the rear major surface 130 of semiconductor assembly 125. Busbars 110a and 110b are thin strips of a highly conductive metal (typically a fired silver paste) that conduct the direct current that the solar cell(s) collects to an electrical inverter, which converts the direct current into useable alternating current. Silver busbars 110a and 110b are solderable. Rear major surface 130 also includes a metalized layer or coating 135 (typically a fired aluminum paste) on the portion of rear major surface 130 that does not include busbars 110b. Metalized layer or coating 135 forms the p-type side of the semiconductor junction.

Examples of PV cells having modified (narrow) busbars are shown, e.g., in the right panel of Fig 2A and in Fig. 2B). In those embodiments, the narrow busbars replace typical busbars 110a. As mentioned before, the narrow busbars used in embodiments of this disclosure are narrower than busbars 110a, and have a width that is comparable to the gridlines (or fingers) 122.

All scientific and technical terms used herein have meanings commonly used in the art unless otherwise specified. The definitions provided herein are to facilitate understanding of certain terms used frequently in this application and are not meant to exclude a reasonable interpretation of those terms in the context of the present disclosure.

Unless otherwise indicated, all numbers in the description and the claims expressing feature sizes, amounts, and physical properties used in the specification and claims are to be understood as being modified in all instances by the term "about." Accordingly, unless indicated to the contrary, the numerical parameters set forth in the foregoing specification and attached claims are approximations that can vary depending upon the desired properties sought to be obtained by those skilled in the art utilizing the teachings disclosed herein. At the very least, and not as an attempt to limit the application of the doctrine of equivalents to the scope of the claims, each numerical parameter should at least be construed in light of the number of reported significant digits and by applying ordinary rounding techniques. Notwithstanding that the numerical ranges and parameters setting forth the broad scope of the invention are approximations, the numerical values set forth in the specific examples are reported as precisely as possible. Any numerical value, however, inherently contains certain errors necessarily resulting from the standard deviations found in their respective testing measurements.

The recitation of numerical ranges by endpoints includes all numbers subsumed within that range (e.g. a range from 1 to 5 includes, for instance, 1, 1.5, 2, 2.75, 3, 3.80, 4, and 5) and any range within that range.

As used in this specification and the appended claims, the singular forms "a", "an", and "the" encompass embodiments having plural referents, unless the content clearly dictates otherwise. As used in this specification and the appended claims, the term "or" is generally employed in its sense including "and/or" unless the content clearly dictates otherwise.

The term "adhesive" as used herein refers to polymeric compositions useful to adhere together two components (adherents).

As used herein, the term "photoactive surface" refers to the surface of the portion of a photovoltaic cell that absorbs photons and releases electrons, which are then collected and converted into electric current. Examples of the photoactive surface of a photovoltaic cell are the silicon wafer (crystalline or amorphous). Typically, silicon wafers are coated with silicon nitride to create an anti-reflective surface.

As used herein, the term "busbar(s)" refers to embodiments where either a single narrow busbar is used, or embodiments where a dual set of narrow busbars is used.

As used herein, the term "in contact with" in the context of one element of a photovoltaic cell being in contact with another separate element refers to the relative position of the two elements, being in physical contact and immediately next to each other without having any other items separating the two elements, as understood by the context in which "in contact with" appears. The term "in contact with," however, encompasses situations where one or both elements have been treated (e.g., a coated primer or anti-reflective coatings,), or whose surface has been modified to affect the properties thereof, such as etching, embossing, etc., or by other surface treatments that may improve adhesion.

As used herein, the term "electrical contact" in the context of one element of a photovoltaic cell being in electrical contact with another separate element refers to contact that allows the flow of electrons from one element to the other.

As used herein, the term "solderable" refers to the property of an item that allows other items in a photovoltaic cell to be soldered to a surface of that item, such as tabbing ribbons being soldered to busbars or to busbar tape using typical methods used in the manufacture of solar modules.

As used herein, the term "room temperature" refers to a temperature of 23°C.

### Brief Description of the Figures

Figure 1A is a top schematic view of a photovoltaic cell.
Figure **1B** is a bottom schematic view of a photovoltaic cell.
**Figure 1C** is a cross-sectional view of a photovoltaic cell taken between and parallel to gridlines.
**Figure 2A** is a photograph comparing a solar cell with conventional thick busbars (left) and a solar cell with narrow busbars (right).
**Figure 2B** is a photograph of a solar cell with narrow busbars.
**Figure 2C** is a photograph of a solar cell with narrow busbars to which front busbar tape has been bonded.
**Figure 3** is an illustration of a portion of a solar cell having no busbars, in which front busbar tape has been bonded to the cell over the gridlines.
Figure 4 is an illustration of a portion of a solar cell having a narrow busbar, in which front busbar tape has been bonded to the cell over the narrow busbar.
Figure 5A is a photograph comparing three solar cells having (left) busbars and gridlines, (center) gridlines only, (right) gridlines only, and with front busbar tape bonded to the cell.
Figure 5B is a photograph of a portion of a solar cell showing gridlines and a front busbar.
Figure 5C is a photograph of a portion of a solar cell having gridlines over which front busbar tape has been bonded.
Figure 6 is a photomicrograph of a cross section of a solar cell showing a gridline over which front busbar tape has been bonded.
Figure 7A is a photograph of a model of a silver gridline.
Figure 7B is a photograph of the model of a silver gridline, further showing a model busbar tape applied over the gridline.
Figure 7C is a photograph of a model of a silver gridline which has a flattened portion.
**Figure 7D** is a photograph of the model of a silver gridline having a flattened portion, further showing a model busbar tape applied over the gridline.
Figure 7E is a photograph of a model of a silver gridline that has a pad over a portion of the gridline to facilitate electrical contact.
Figure 7F is a photograph of the model of the silver gridline having the pad, further showing a model busbar tape applied over the gridline and pad.
Figure 8A illustrates a process for bonding a front busbar tape to a narrow front busbar.
**Figure 8B** illustrates a process for bonding a front busbar tape to dual narrow front busbars.
Figure 9 is a drawing of a portion of a solar cell showing two narrow busbars connected to gridlines.
Figure 10A is a photograph of a photovoltaic cell having three 70 micron wide front busbars.
Figure 10B is a photograph of a photovoltaic cell with front gridlines but no front busbars.
Figure 11 is a plot of Fill Factor as a function of number of thermal cycles.
Figure 12A is a photograph showing adhesive squeeze out from Test Cell 1.
Figure 12B is a photograph showing adhesive squeeze out from Comparative Test Cell.
**Figure** 12C is a photograph showing adhesive squeeze out from Test Cell 2.
Figure 12D is a photograph showing adhesive squeeze out from Test Cell 3.
Figure 13A is an illustration of a photovoltaic cell, with the expanded area shown in Figures 13B indicated.
Figure 13B is an illustration of an expanded view of a portion of the photovoltaic cell shown in Figure 13A.
Figure 13C is an illustration of a portion of a PV cell after application of busbar tape.

### Element Numbers

- 100:: Photovoltaic cell
- 110a:: Silver busbars on front major surface of semiconductor
- 110b:: Silver busbars on rear major surface of semiconductor
- 122:: Gridlines
- 120:: Front major surface of semiconductor 125
- 125:: Semiconductor
- 130:: Rear major surface of semiconductor 125
- 135:: Metalized layer or coating (typically aluminum) on the portion of rear major surface 130 that does not include busbars 110b
- 302:: Gridlines
- 304:: Front busbar tape
- 306:: Area of electrical junction with good contact between gridlines and front busbar tape
- 308:: Area of electrical junction with poor contact between gridlines and front busbar tape
- 402:: Gridlines
- 404:: Front busbar tape
- 406:: Area of electrical junction with good contact between gridlines and front busbar tape
- 408:: Area of electrical junction with poor contact between gridlines and front busbar tape
- 410:: Narrow front busbar
- 602:: Gridline
- 604:: Front busbar tape
- 606:: Semiconductor wafer of solar cell
- 802:: Narrow busbar
- 804:: Front busbar tape
- 806:: Copper foil
- 808:: Adhesive
- 810:: Semiconductor wafer of solar cell
- 812:: Front busbar tape bonded to the surface of the solar cell and narrow busbar
- 814:: Stringing ribbon
- 816:: String ribbon soldered to front busbar tape that has been bonded to the surface of the solar cell and narrow busbar
- 822:: Narrow busbars
- 824:: Front busbar tape
- 826:: Copper foil
- 828:: Adhesive
- 830:: Semiconductor wafer of solar cell
- 832:: Front busbar tape bonded to the surface of the solar cell and each of the narrow busbars
- 834:: Stringing ribbon
- 836:: String ribbon soldered to front busbar tape that has been bonded to the surface of the solar cell and each of the narrow busbars
- 902:: Gridlines
- 904:: Narrow busbars
- 1310:: Portion of a solar cell with dual busbars
- 1312:: Edge of solar cell
- 1314:: Surface of semiconductor wafer of solar cell
- 1316:: Gridline
- 1318:: Front busbars
- 1320:: Gap between front busbars
- 1322:: Front busbar tape covering front busbars 1318 and gap between busbars 1320

### Detailed Description

In one embodiment, the modified narrow busbars of this disclosure (either a single busbar or a dual set of busbars) act as a substrate for single busbar tape. That is, the busbar tape is placed on top of the narrow busbar(s) of a PV solar cell. In that manner, there is electrical contact between the narrow busbar(s) and the busbar tape. In addition, the busbar tape placed on the PV cell also creates an electrical contact with the silver paste gridlines. In other embodiments, the silver gridlines are modified to enhance the electrical contact between the busbar tape and the gridlines. The modified gridlines as disclosed in this application can be used in a PV cell with the modified narrow busbar(s) or without the narrow busbar(s).

The panels in Figure 2 show schematically a PV cell with narrow single silver busbars (Figs. 2A (right panel) and Fig. 2B) and then a PV cell having the busbar tape bonded to a narrow busbar and in electrical contact with the narrow single silver busbars (Fig. 2C). In this disclosure, the busbars may be referred to as "silver" busbars to indicate that the busbars are made of the typical silver paste, which has been fired at high temperature (about 800°C) in a furnace. For convenience and simplicity, the present disclosure may refer to silver busbars. However, the narrow busbars that can be used in embodiments of this disclosure are not necessarily limited to silver busbars and any other material suitable for a busbar can be used in the instant embodiments.

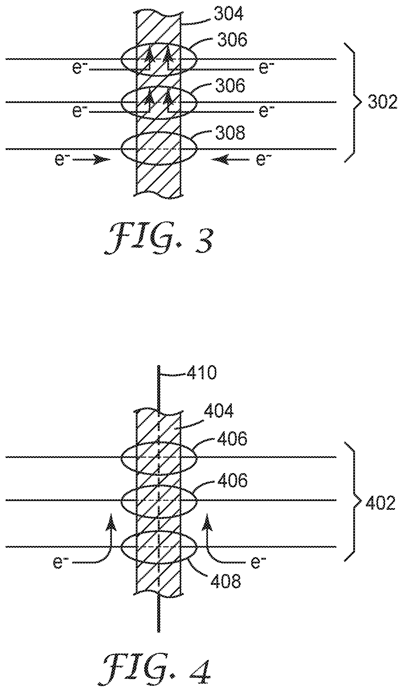

Whether a single narrow busbar or a dual set of narrow busbars are used, and without wishing to be bound by theory, the apparent role of the front narrow busbar(s) is illustrated with the aid of Figures 3 and 4. Figure 3 shows a busbar tape (304) that is bonded to three gridlines (302) only (no narrow silver busbar). In the diagram, the electrical connection (308) between the busbar tape and the lower-most gridline is no longer working (the connection highlighted by the two arrows). In that situation, the electrons in that gridline have no pathway to exit the solar cell, and that particular gridline area will go "dark" in the solar cell.

The drawing in Figure 4 illustrates three gridlines (402) that are connected to a single narrow busbar (although it could have also been connected to a dual set of narrow busbars, not shown). The narrow busbar(s) are bonded to a front busbar tape (404). In this scenario, if the electrical connection (408) between the lower-most gridline and the busbar tape no longer works (i.e., there is no flow of electrons from the gridline to the busbar tape), the electrons can travel a short distance along the front narrow busbar(s) until a "good" electrical connection (406) to the front busbar tape is found. At that point, the electrons can travel through the copper busbar tape and make their way out of the PV cell. The narrow front busbar(s) provide alternative short pathways between gridlines to ensure that electrons can find a low resistance pathway into the busbar tape and out of the PV cell.

Figure 2A shows a typical crystalline silicon solar cell on the left panel with a 1.5 mm wide front busbar. The cell on the right in the picture below has a "narrow" (i.e. modified) front busbar, which is 70 microns wide. The gridlines on both cells are about 70 microns.

### Embodiments of PV cells with busbar tape and single narrow busbars

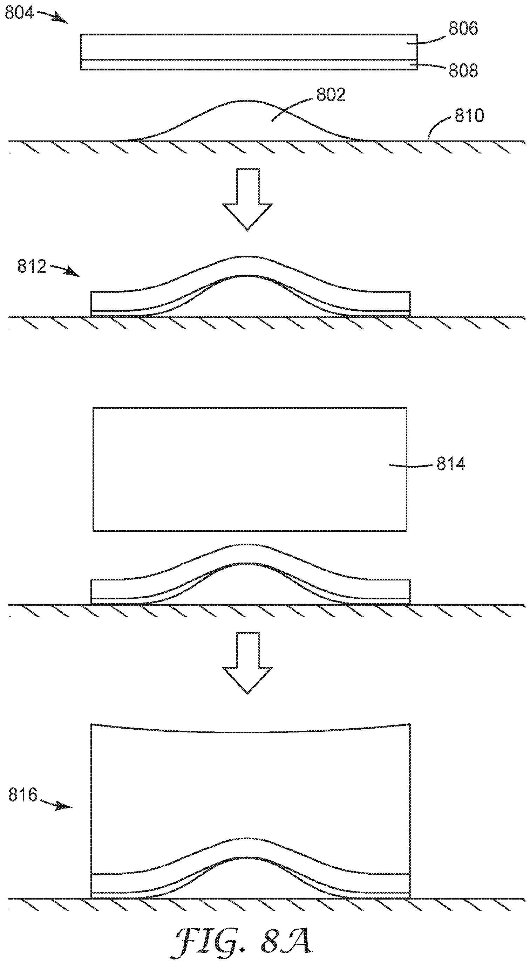

The concept of using busbar tape on a PV cell with single narrow busbars is illustrated in Figure 8A. In the first top panel, the mound represents the single narrow busbar (802). The substrate on which the narrow busbar rests (the shaded area) represents the photoactive surface of the PV cell (810), which may have an anti-reflective coating, such as silicon nitride. The bar with two layers, above the narrow busbar, represents the busbar tape (804), with the lower layer being the adhesive (808) and the top layer being the metal foil (806).

The second panel from the top in Figure 8A shows the busbar tape bonded (812) to the single narrow busbar. In the third panel from the top in Figure 8A, the big block above the busbar tape represents the tabbing ribbon (814). The fourth panel from the top in Figure 8A shows the tabbing ribbon (copper foil coated with solder) soldered (816) to the busbar tape. The solder is not explicitly identified in that figure, but it is present in at least some portions in between the tabbing ribbon and the busbar tape.

It should be noted that in embodiments using a single busbar to bond the busbar tape, the tabbing ribbon is not in (direct) contact with the narrow busbar. In some embodiments, depending on the width of the busbar tape, the tabbing ribbon may be in contact with the photoactive surface either. In embodiments (less preferred) where the width of the busbar tape is narrower than the width of the tabbing ribbon, the tabbing ribbon may be in contact with the photoactive surface.

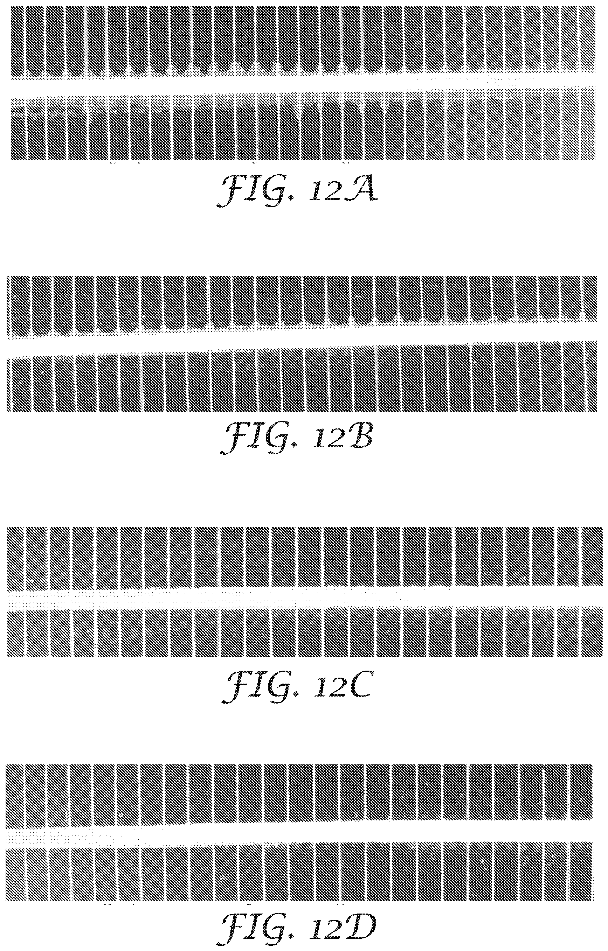

In embodiments having a single narrow busbar, the adhesive may squeeze out when the busbar tape is applied to the narrow busbar/photoactive surface, as shown, for example, in Figures 12A and 12B. In those figures, the white thick horizontal bar represents the busbar tape and the white thin vertical lines represent the gridlines. The dark background represents the photoactive surface of the PV cell. In those figures, the adhesive squeeze out is represented by the irregular grey area next to the busbar tape extending into and over the photoactive surface.

The adhesive squeeze out is aesthetically undesirable and may also block photons from reaching the photoactive surface. However, modules prepared with PV cells having squeeze out may still perform satisfactorily when considered the savings due to less silver paste used in the cells versus the reduced energy output. Figures 12C and 12D show embodiments where the is no noticeable squeeze out.

In some examples not falling within the scope of the claims, the present disclosure is directed to a photovoltaic cell comprising:
- a photoactive surface,
- a continuous busbar in contact with the photoactive surface,
- a busbar tape in electrical contact with the continuous busbar,
wherein the continuous busbar has a width no larger than 150 microns,
wherein at least a portion of the busbar tape is adhered to the photoactive surface and the busbar via a nonconductive thermoset adhesive, and
wherein the busbar tape is solderable and comprises a conductive metal foil.

In other examples not falling within the scope of the claims, the present disclosure is directed to a photovoltaic cell comprising:
- a photoactive surface,
- a continuous busbar in contact with the photoactive surface,
- a busbar tape in electrical contact with the continuous busbar,
wherein the continuous busbar has a width no larger than 150 microns,
wherein at least a portion of the busbar tape is adhered to the photoactive surface and the busbar via a conductive thermoset adhesive, and
wherein the busbar tape is solderable and comprises a conductive metal foil.

Yet in other examples not not falling within the scope of the claims, the present disclosure is directed to a photovoltaic cell comprising:
- a photoactive surface,
- a continuous busbar in contact with the photoactive surface,
- a busbar tape in electrical contact with the continuous busbar,
- a stringing ribbon soldered to the busbar tape,
wherein the continuous busbar has a width no larger than 150 microns,
wherein at least a portion of the busbar tape is adhered to the photoactive surface and the busbar via a nonconductive thermoset adhesive, and
wherein the busbar tape is solderable and comprises a conductive metal foil.

In the embodiments according to the invention, the present disclosure is directed to a photovoltaic cell as defined by the subject-matter of claim 1 comprising:
- a photoactive surface,
- a continuous busbar in contact with the photoactive surface,
- a busbar tape in electrical contact with the continuous busbar,
- a stringing ribbon soldered to the busbar tape, the busbar tape comprising a conductive metal foil and a nonconductive thermoset adhesive,
wherein the continuous busbar has a width from 50 microns to 90 microns,
wherein at least a portion of the busbar tape is adhered to the photoactive surface and the busbar via the nonconductive thermoset adhesive, and
wherein the busbar tape is solderable

### Busbar tape and adhesive

In general terms, the busbar tape that can be used in the embodiments of this disclosure is not limited. A typical busbar tape useful in the instant emnbodiments comprises a conductive metal foil and a nonconductive thermoset adhesive, wherein the tape is solderable and capable of adhering to the photoactive surface of a PV cell (e.g., amorphous or crystal silicon material). The adhesive is used to bond the metal foil to the photoactive surface. In other examples not falling within the scope of the claims, the adhesive is a conductive adhesive comprising a thermoset adhesive with conductive particles. Any type of conductive particles used in known conductive adhesives may be used in the adhesive of the busbar tape.

Any metal foil may be used in the busbar tape of the present disclosure. Exemplary metal foil materials include, for instance, copper, aluminum, tin, iron, nickel, silver, gold, lead, zinc, cobalt, chromium, titanium, and the like. The metal foil layers may be of any desired thickness. Some embodiments have a metal foil layer thickness that is between about 5 microns and about 35 microns. Some embodiments have a metal foil layer thickness that is between about 5 microns and about 20 microns. Some embodiments have a metal foil layer thickness that is between about 5 microns and about 15 microns. In some embodiments, the thickness of the tape is 5 microns, or 6 microns, or 7 microns, or 8 microns, or 9 microns, or 10 microns, 11 microns, or 12 microns, or 13 microns, 14 microns, or 15 microns. In some embodiments, the metal foil thickness is any thickness that does not cause an unacceptable level or bowing or warping of the solar cell or that does not create an unacceptable electrical contact with the silver gridlines. Some embodiments of the conductive tapes and solar cells described herein exhibit bowing or warping of less than 3mm. Some embodiments of the conductive tapes and solar cells described herein exhibit bowing or warping of less than 2mm. Some embodiments of the conductive tapes and solar cells described herein exhibit bowing or warping of less than 1.5mm.

In certain embodiments of the front-side busbar tape, the tape is sufficiently flexible to conform to the fine silver gridlines on the front side of a photovoltaic cell when bonded under pressure or under hot-pressing conditions. In other embodiments, the front-side busbar tape is capable of adhering to silicon photovoltaic material (via adhesion to the silicon nitride layer coating the photoactive surface, when present), as well as the fine silver gridlines on the front side of a photovoltaic cell and make an electrical connection with those silver gridlines.

The metal foil layers may have any desired amount of electrical conductivity. Some embodiments have a metal foil layer electrical conductivity that is greater than 5 x 107 S/m at 23° C. Some embodiments have a metal foil layer electrical conductivity that is greater than 1 x 106 S/m at 20°C.

In certain embodiments, the metal foil comprises a passivated Electro-Deposited (ED) High Temperature Elongation (HTE) Copper foil. In other embodiments, the metal foil comprises a Zn barrier layer to keep the foil from corroding or oxidizing. In some embodiments, the elongation of the copper foil is from 6 to 11%. In other embodiments, the elongation of the copper foil is 6 percent, or 7 percent, or 8 percent, or 9 percent, or 10, percent, or 11 percent, or 12 percent.

In certain embodiments, the tensile strength of the foil tape is from 20 to 40 Kpsi. In other embodiments the tensile strength is from 25 to 35 Kpsi. In some embodiments, the tensile strength is 25 Kpsi, or 26 kpsi, or 27 Kpsi, or 28 kpsi, or 29 Kpsi, or 30 kpsi, or 31 Kpsi, or 32 kpsi, or 33 Kpsi, or 34 kpsi, or 35 Kpsi.

Any nonconductive adhesives may be used in the busbar tape of the present disclosure. In some embodiments, the adhesive comprises an epoxy resin and a phenoxy resin. In other embodiments, the adhesive comprises fumed silica particles. Yet in other embodiments, the adhesive is tacky at the temperature at which the busbar tape is applied to the photovoltaic cell (e..g, room temperature, or slightly elevated temperature , such as from 40°C to 60°C). In some embodiments, the adhesive comprises an epoxy resin, a phenoxy resin, and fumed silica particles.

In some embodiments, the nonconductive adhesive has an acceptable room temperature shelf life. As used herein, the term "shelf life" refers to the time period at room temperature over which the adhesive remains tacky enough to allow the tape to remain flat once applied to the frontside of a solar cell and after which the tape is able to endure at least 200 cycles of thermal cycling (-40° C to 90° C) and damp heat (85°C/85% Relative Humidity testing) for at least 1000 hours with less than 5% decrease in fill factor. In other embodiments, there is a less than 5% Pmax under the same thermal cycling and damp heat aging conditions. In some embodiments of the present disclosure, the room temperature shelf life of the nonconductive adhesive and/or the busbar tape is at least a 3 week shelf life. In some embodiments of the present disclosure, the room temperature shelf life of the nonconductive adhesive and/or the conductive tape is at least a 4 week shelf life. In some embodiments of the present disclosure, the room temperature shelf life of the nonconductive adhesive and/or the conductive tape is at least a 5 week shelf life. In some embodiments of the present disclosure, the room temperature shelf life of the nonconductive adhesive and/or the conductive tape is at least a 6 week shelf life.

Exemplary nonconductive adhesives include epoxy resins, acrylic resins, polyurethanes, polyesters, polyimides, polyamides, cyanate esters, phenolic resins, maleimide resins, phenoxy resins, benzoxazine resins, and the like.

Some embodiments of the nonconductive adhesive include a thermoset adhesive. As used herein, the term "thermoset" refers to a resin which changes irreversibly under the influence of energy from a fusible and soluble material into one that is infusible and insoluble through the formation of a covalently crosslinked, thermally stable network. Exemplary thermoset adhesives include epoxy resins, acrylic resins, polyurethanes, polyesters, cyanate esters, phenolic resins, maleimide resins, and the like.

The adhesive layer non conductive) for the front-side busbar tape may be of any desired thickness. Some embodiments have an adhesive layer thickness that is between about 5 microns and about 50 microns. Some embodiments have an adhesive layer thickness that is between about 5 microns and about 30 microns. Some embodiments have an adhesive layer thickness that is between about 5 microns and about 20 microns. Some embodiments have an adhesive layer thickness that is between about 1 microns and about 20 microns. Some embodiments have an adhesive layer thickness that is between about 5 microns and about 15 microns. Some embodiments have an adhesive layer thickness that is between about 5 microns and about 15 microns. Some embodiments have an adhesive layer thickness that is between about 8 microns and about 13 microns. In some embodiments, the adhesive layer thickness is about 1 microns, 2 microns, 3 microns, 4 microns, 5 microns, 6 microns, 7 microns, 8 microns, 9 microns, 10 microns, 11 microns, 12 microns, 13 microns, 14 microns, 15 microns, 16 microns, 17 microns, 18 microns, 19 microns, 20microns, 21 microns, 22 microns, 23microns, 24 microns, 25microns, or 26 microns.

In its uncured state, the adhesive can have any desired tackiness, provided that the adhesive is tacky enough at room temperature to allow the tape to be applied to the front side of a solar cell at about 0.35 MPa of pressure and subsequently prevent the tape from lifting more than 2 mm at room temperature without the application of any external force

PCT Application Publication Nos. WO2014/149714 and WO2014/149715 disclose busbar tapes and adhesives that can be used in the embodiments of this patent application. The disclosure of both PCT applications is incorporated by reference herein for their disclosure of busbar tapes and busbar tape adhesives.

### Embodiments of PV cells with busbar tape and dual narrow busbars

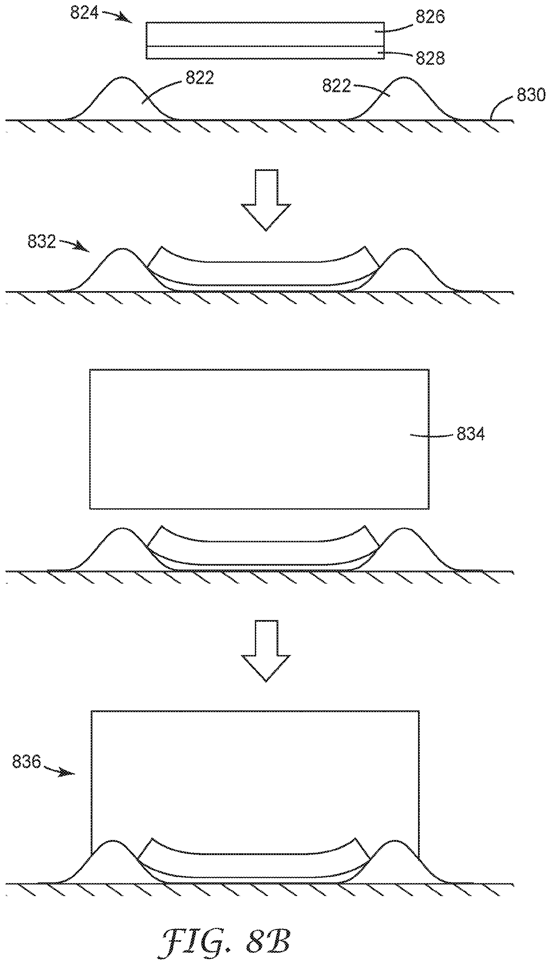

The concept of using busbar tape on a PV cell with dual narrow busbars is illustrated in Figure 8B. In the first top panel, the two mounds represent the dual narrow busbars (822). The substrate on which the narrow busbars rest (the shaded area) represents the photoactice surface of the PV cell (830), which may have an anti-reflective coating, such as silicon nitride. The bar with two layers, above the valley in between the two narrow busbars, represents the busbar tape (824), with the lower layer being the adhesive (828) and the top layer being the metal foil (826).

The second panel from the top in Figure 8B shows the busbar tape bonded (832) to both the photoactive surface and each of the two narrow busbars. In this case, there is electrical contact between the busbar tape and each of the two narrow busbars. In certain preferred embodiments, the width of the busbar tape is narrower than the distance between the two peaks of the two narrow busbars (the top of the narrow busbars). In the third panel from the top in Figure 8B, the big block above the busbar tape represents the tabbing ribbon (834). The fourth panel from the top in Figure 8B shows the tabbing ribbon soldered (836) to both the busbar tape and each of the two narrow busbars. The solder is not explicitly identified in that figure, but it is present in at least some portions in between the tabbing ribbon and the busbar tape and in at least some portions in between the tabbing ribbon and one or both of the narrow busbars.

As can be seen from Figure 8B, in embodiments using dual busbars to bond the busbar tape, the tabbing ribbon is not only in contact with the busbar tape, but is also in contact with each of the narrow busbars.

In embodiments having dual narrow busbars, the busbar tape is bonded between the narrow busbars. In some embodiments, the narrow busbars are parallel to each other. In other embodiments, the narrow busbar are not necessarily parallel, but they do not touch each other. In other embodiments, the tape makes an electrical connection to each of the narrow busbars through the edge portions of the busbar tape.

The inventor has identified at least three possible advantages of the dual narrow front busbar concept over the use of a single narrow busbar:
1. The busbar tape is essentially bonded to a flat surface (i.e. the tape is not bonded over an elevated ridge (single narrow busbar), which is expected to provide better 180 degree peel values.
2. The narrow busbars essentially act as "dams" to reduce adhesive squeeze out. This circumstance allows the use of a thicker adhesive, which may also contribute to better 180 degree peel values.
3. The stringing ribbon is soldered directly to both narrow silver busbars as well as to the busbar tape. Consequently, a robust electrical connection of the busbar tape to the silver busbars may not be a necessary requirement in these systems because the flow of electrons from the narrow busbars to the tabbing ribbon can be carried out by direct contact between those elements, bypassing the busbar tape. Under these circumstances, the busbar tape may be used to enhance the peel properties of the stringing ribbon soldered to the busbar tape.

In some examples not falling within the scope of the claims, the present disclosure is directed to a photovoltaic cell comprising:
- a photoactive surface,
- two continuous busbars in contact with the photoactive surface,
- a busbar tape in electrical contact with each of the two continuous busbars,
- a stringing ribbon soldered to the busbar tape and soldered to each of the two continuous busbars,
wherein each of the two continuous busbars has a width no larger than 150 microns and the two continuous busbars are separated from each other by a distance from 0.3 mm to 3 mm,
wherein the busbar tape is adhered to the photoactive surface and to each of the two busbars via a nonconductive thermoset adhesive, and
wherein the busbar tape is solderable and comprises a conductive metal foil.

In some examples not falling within the scope of the claims, the present disclosure is directed to a photovoltaic cell comprising:
- a photoactive surface,
- two continuous busbars in contact with the photoactive surface,
- a busbar tape in electrical contact with each of the two continuous busbars,
- a stringing ribbon soldered to the busbar tape and soldered to each of the two continuous busbars,
wherein at least one of the two continuous busbars has a width no larger than 150 microns and the two continuous busbars are separated from each other by a distance from 0.3 mm to 3 mm,
wherein the busbar tape is adhered to the photoactive surface and to each of the two busbars via a conductive thermoset adhesive, and
wherein the busbar tape is solderable and comprises a conductive metal foil.

Yet in other examples not falling within the scope of the claims, the present disclosure is directed to a photovoltaic cell comprising:
- a photoactive surface,
- two continuous busbars in contact with the photoactive surface,
- a busbar tape in electrical contact with each of the two continuous busbars,
- a stringing ribbon soldered to the busbar tape and soldered to each of the two continuous busbars,
- a plurality of gridlines in contact with the photoactive surface,
wherein at least one of the two continuous busbars has a width no larger than 150 microns,
wherein the two continuous busbars are separated from each other by a distance from 0.3 mm to 3 mm,
wherein at least one of the plurality of gridlines is in electrical contact with one or both of the continuous busbars,
wherein at least one of the plurality of gridlines is laid down in a direction substantially perpendicular to at least one of the busbars,
wherein the busbar tape is adhered to the photoactive surface and to each of the two busbars via a nonconductive thermoset adhesive, and
wherein the busbar tape is solderable and comprises a conductive metal foil.

In 2. some embodiments, the present disclosure is directed to a photovoltaic cell comprising:
- a photoactive surface,
- two continuous busbars in contact with the photoactive surface,
- a busbar tape in electrical contact with each of the two continuous busbars, the busbar tape comprising a conductive metal foil and a non conductive thermoset adhesive,
- a stringing ribbon soldered to the busbar tape and soldered to each of the two continuous busbars,
- a plurality of gridlines in contact with the photoactive surface,
wherein at least one of the two continuous busbars has a width from 50 microns to 90 microns,
wherein the two continuous busbars are separated from each other by a distance from 0.3 mm to 3 mm,
wherein at least one of the plurality of gridlines is in electrical contact with one or both of the continuous busbars,
wherein at least one of the plurality of gridlines is laid down in a direction substantially perpendicular to at least one of the busbars,
wherein the busbar tape is adhered to the photoactive surface and to each of the two busbars via nonconductive thermoset adhesive, and
wherein the busbar tape is solderable

### Modified Gridlines and Busbar(s)

In certain embodiments, the gridlines of a PV cell are modified to enhance the electrical connection with a busbar tape. One problem identified by the inventor when bonding the busbar tape to the silver paste gridlines is that the resulting bonded structure resembles a tent with the silver paste gridline essentially functioning as the center pole of the tent.

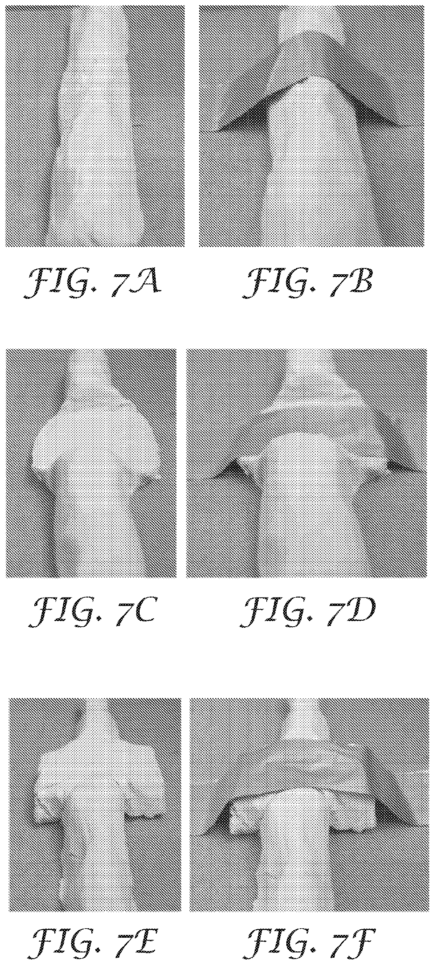

Fig. 7A shows schematically a representation of a typical gridline. Figure 7B shows a piece of busbar tape bonded to the gridline. Fig. 7B shows that the surface area of the busbar tape making an electrical connection with the gridline may be limited.

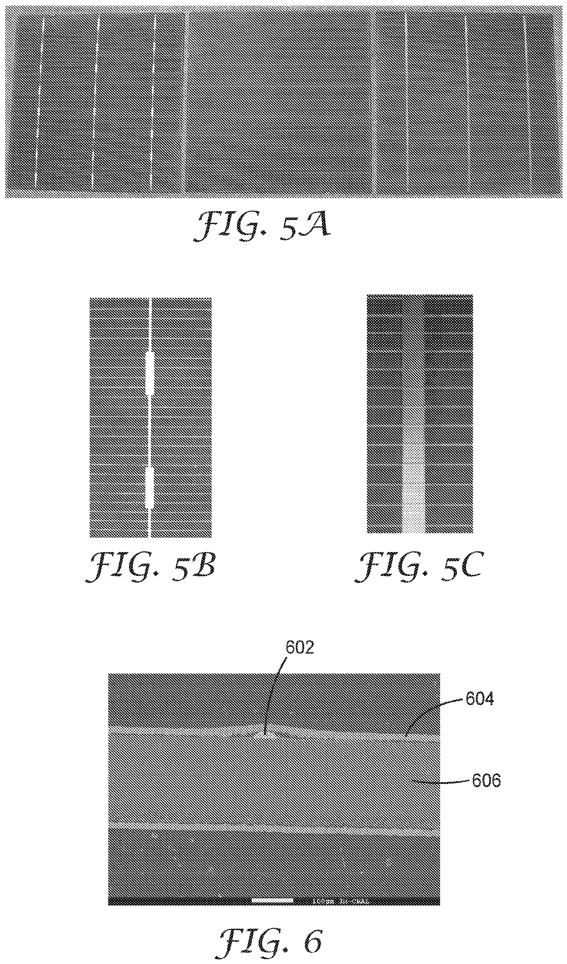

Indeed, the micrograph in Figure 6 shows a cross section of a solar cell with busbar tape bonded on the frontside (and backside) of PV cell, with a silver gridline (602), a silicon wafer (606), and frontside busbar tape (604) bonded to the gridline.

As can be seen in Figure 6, in this construction, the busbar tape is only bonded to the silver paste gridline in a limited area at the very top portion of the gridline. Under these circumstances, because of this limited bonding area to the gridline, the electrical bond between the silver paste gridline and the busbar tape may not be as robust it could otherwise be.

In some embodiments, the silver paste gridlines are modified using two general approaches to increase the bonded area between the busbar tape and the silver paste gridline. When considering such gridline modifications, it is important to keep in mind that silver paste gridlines are printed onto the solar cell surface using a screen printing technique. In one embodiment, when screen printing process is used, then some limitations are present on the type of gridline modifications that can be realized.

In one embodiment, the modification is illustrated in Figures 7C and 7D, which show a flattened area created on the silver paste gridline (or busbar(s)). Figure 7C shows only the modified gridline and Figure 7D shows the busbar tape bonded to the modified gridline.

It is possible that the flattened area could be created with a mechanical stamping process on the uncured (or even on a partially cured/dried) silver paste after screen printing and before the firing process. With a silver paste gridline modified with a flattened area as depicted in Figure 7D, the bonding area of the busbar tape is greatly increased, and therefore a more robust electrical connection to the silver paste gridline is created. An advantage with this embodiment is that the busbar tape does not need to be elevated as much from the main plane of the silicon nitride surface, and, therefore, the amount of "tenting" on both sides of the gridline is reduced. Also, in another embodiment, it may be beneficial to widen the flatten area of the silver paste gridline relative to what is depicted in Figures 7C and 7D, since this would ensure that the bonding head of the bonding machine would have enough clearance to properly contact the busbar tape.

In another embodiment, the modification is illustrated in Figures 7E and 7F. In this approach, a so-called "high plateau" pad region is printed on the silver paste gridline, which provides an increased bonding area between the busbar tape and the gridline. One advantage of this embodiment is that a mechanical stamping process is not needed. In this embodiment, the busbar tape needs to be elevated to the full height of the gridlines, and therefore more "tenting" may still occur on both sides of the modified gridline pad region.

There are further gridline modifications that are part of this disclosure to provide an enhanced bonding region for the busbar tape. For example, the "high plateau" approach could be further modified by a mild mechanical stamping process to give the "plateau" region a sloped shape with the top of the slope aligned with the top of the unmodified gridlines. The bonding area on the modified gridline would then slope downwards on both sides of the gridline from the center high plateau. This sloping could reduce (or even almost eliminate) any undesired "tenting" effect. The gridline could be modified by creating a pad.

Another embodiment involves both the solar cell with a modified silver paste gridline and the busbar tape. An advantage of this embodiment is that, even when the frontside busbar has been replaced with modified gridlines that results in a significant reduction of silver paste, the peel strength between the soldered interconnect ribbon and the solar cell meets the requirements that are generally accepted in the solar panel industry.

Other embodiments include a PV cell comprising the gridlines of the disclosure, as well as a solar module comprise a plurality of PV cells comprising the gridlines of the disclosure. Yet other embodiments are directed to methods of making a connection between a busbar tape and a gridline as described above.

The modifications described above for gridlines can also be used to modify the narrow busbar(s) to enhance the electrical connection between the narrow silver busbar(s) and the busbar tape.

The panels in Figure 5A illustrate the idea of replacing the conventional front silver paste busbar with bonded strips of busbar tape using modified busbar(s). The left panel in Figure 5A show a crystalline silicon photovoltaic cell with front silver busbars and silver gridlines. The center panel in Figure 5A show a crystalline silicon photovoltaic cell with only silver gridlines, but no front silver busbars. The right panel in Figure 5A show a crystalline silicon photovoltaic cell with silver gridlines and busbar tape.

The panel in Figure 5B shows a PV cell with a modified frontside silver busbar and regular frontside silver gridlines.

Figure 5C shows the busbar tape bonded to both the blue silicon nitride surface of the PV cells, as well as bonded to the silver gridlines. In that close-up photograph, on can see the busbar tape wrapping around the silver paste gridlines.

### Examples

These Examples are merely for illustrative purposes and are not meant to be overly limiting on the scope of the appended claims. Notwithstanding that the numerical ranges and parameters setting forth the broad scope of the present disclosure are approximations, the numerical values set forth in the specific examples are reported as precisely as possible. Any numerical value, however, inherently contains certain errors necessarily resulting from the standard deviation found in their respective testing measurements.

### Summary of Materials

Unless otherwise noted, all parts, percentages, ratios, etc. in the Examples and the rest of the specification are by weight. Solvents and other reagents used may be obtained from Sigma-Aldrich Chemical Company (Milwaukee, WI) unless otherwise noted. In addition, Table 1 provides abbreviations and a source for all materials used in the Examples below:

**Table 1: Materials.**

| **Ingredient** | **Trade Designation or abbreviation** | **Supplier** |
|---|---|---|
| Epoxy resin | EPON SU-2.5 | Momentive (Columbus, OH) |
| 40% Phenoxy resin in methyl ethyl ketone | PKHS-40 | InChem Corp (Rock Hill, SC) |
| Core-shell particles | PARALOID EXL-2330 | Dow Chemical (Midland, MI) |
| Epoxy resin curative | 2MZ-AZINE (fine grind) | Air Products (Allentown, PA) |
| 2-Butanone | Methyl Ethyl Ketone (MEK) | Brenntag Great Lakes (Reading, PA) |
| Fumed Silica | R-805 | Evonik (Parsippany, NJ) |
| Acrylic resin, 40% solution in 97/3 ethyl acetate/isopropanol | Methyl acrylate/butyl acrylate/glycidal methacrylate (80/15/5). | 3M Company (St. Paul, MN) |
| Araldite MT35600 | Benzoxazine resin | Huntsman (The Woodlands, TX) |
| Butyl acrylate | BA | BASF (Germany) |
| Methyl acrylate | MA | BASF (Germany) |
| Glycidyl methacrylate | GMA | Dow Chemical (Midland, MI) |
| 2,2'-azobis(2-methylbutyronitrile) | VAZO-67 | Du Pont (Wilmington, DE) |
| Ethyl acetate solvent | EA | Shanghai Wujing Chemical Co., Ltd. (China) |

### Aging Tests

Two-cell test modules prepared as described below were placed in an environmental chamber (model "ESZ-4CA", obtained from ESPEC, Hudsonville, MI) set to continuously cycle between temperatures of about -40°C and 90°C over a five hour period. The modules remained in the environmental chamber for up to 2000 hours or 400 thermal cycles.

### Photovoltaic Module Testing

Photovoltaic module testing on 2-cell test modules was done on a Spi-Sun Simulator 3500 SLP Photovoltaic Module Tester (Spire Corp., Bedford, MA). The software for this photovoltaic module tester calculates various values for parameters from the current-voltage curve such as fill factor (FF), open circuit voltage (V_{oc}), short circuit current (I_{sc}), maximum power (Pₘₐₓ), shunt resistance (Rₛ), and efficiency. Prior to each measurement made with the Photovoltaic Module Tester, a calibration module was run. After initial module testing with the photovoltaic module tester, the 2-cell modules were placed in environmental chambers and periodically removed for module testing.

### Example 1

A solvent-based epoxy thermoset adhesive was prepared using the materials listed in Table 2, wherein the amount of each ingredient is expressed as weight percent (wt.%) based on the total adhesive weight. The Epon SU-2.5 epoxy resin was heated to 60°C prior to compounding. The charge 1 ingredients were added in the order listed in Table 2, and the combined charge 1 materials were mixed aggressively with a Cowles-type mixer for one hour. The second charge of MEK was then added slowly with mixing, and the resulting mixture was gently mixed for five minutes. The adhesive mixture was subsequently filtered through a 100 micron filter.

**Table 2: Epoxy adhesive with Core-Shell Particle.**

| **Charge** | **Ingredient** | **wt.%** |
|---|---|---|
| 1 | Epoxy resin | 29.9 |
| 1 | 40% Phenoxy resin in methyl ethyl ketone | 10.0 |
| 1 | Core-shell particles | 4.0 |
| 1 | Epoxy resin curative | 2.1 |
| 1 | MEK solvent | 6.6 |
| 2 | MEK solvent | 47.4 |

The adhesive mixture was further filtered through a 30 micron filter and then coated onto the primed side (dull side) of a 21.25 inch wide and 12 micron thick copper foil ("TOB-III" from OakMitsui, Camden, SC). The line speed of the coating process was 60 ft/min. The adhesive layer was dried in a series of drying ovens set, respectively, at 130°F, 150°F, and 170°F. The adhesive layer was subsequently passed through two standard 25-foot-long drying ovens set at 170°F. The dried adhesive layer had a thickness of about 9-10 microns. A release liner (25 micron thick, obtained under the trade name "T-50", from Eastman Chemical Co., Martinsville, VA) was laminated over the adhesive layer. The stockroll of busbar tape was stage slit down to a width of 104 mm, followed by slitting down to a width of 1.5 mm using a small, manually operated rotary die slitter (Wilson Manufacturing, St. Louis, MO).

### Comparative Example 1

The same procedure was used as is described for Example 1 with the exception that the adhesive layer thickness was about 5 microns, and the busbar tape was slit to a width of 1.5 mm using rotary shear slitting.

### Example 2

A solvent-based epoxy thermoset adhesive was prepared using the materials listed in Table 3, wherein the amount of each ingredient is expressed as weight percent based on the total adhesive weight. The Epon SU-2.5 epoxy resin was heated to 60°C prior to compounding. The charge 1 materials were combined and manually mixed until a homogenous mixture resulted. The charge 2 material (epoxy resin curative) was then added and mixed manually until the material was homogeneous. Next, the charge 3 ingredients were added. The fumed silica in charge 3 was added in nine increments with extensive manual mixing after each addition, and solvent was also added in three incremental portions with extensive manual mixing. After the charge 4 solvent was added, a thick, creamy material resulted. The mixture was then mixed with a high speed Cowles-type mixer. After extensive mixing, the charge 5 solvent was added which reduced the percent solids to about 40%. The mixture was then filtered through a 100 micron filter. The adhesive mixture was further filtered through a second 100 micron filter and then coated onto the primed side (dull side) of a 21.25 inch wide and 12 micron thick copper foil ("TOB-III" from OakMitsui, Camden, SC). The line speed of the coating process was 60 ft/min. The adhesive layer was dried in a series of drying ovens set, respectively, at 130°F, 150°F, and 170°F. The adhesive layer was subsequently sent through two standard 25-foot-long drying ovens set at 170°F. The dried adhesive layer had a thickness of about 6-7 microns. The release liner (25 micron thick, obtained under the trade name "T-50", from Eastman Chemical Co., Martinsville, VA) was laminated over the adhesive layer. The stockroll of busbar tape was stage slit down to a width of 104 mm, followed by rotary shear slitting down to a width of 1.5 mm.

**Table 3: Epoxy adhesive with Fumed Silica.**

| **Charge** | **Ingredient** | **wt.%** |
|---|---|---|
| 1 | Epoxy Resin | 29.9 |
| 1 | 40% Phenoxy resin in methyl ethyl ketone | 10.0 |
| 1 | MEK (first charge) | 3.3 |
| 2 | Epoxy Resin Curative | 2.1 |
| 3 | MEK (second charge) | 4.8 |
| 3 | Fumed Silica | 4.0 |
| 4 | MEK | 22.0 |
| 5 | MEK | 23.9 |

### Example 3

The same copper foil was used as is described in Example 1. A solvent based adhesive was prepared using the ingredients listed in Table 4, wherein the amount of each ingredient is expressed as weight percent based on the total adhesive weight.

The acrylic resin was prepared by combining methyl acrylate, butyl acrylate, glycidyl methacrylate, a 97:3 mixture of ethyl acetate and isopropanol, and VAZO-67 in weight ratio of 80/15/5/149.8/0.2 in a 500-mL three-necked flask, and stirring with a pneumatic agitator (Model ZD-J-1, Shanghai Zoda Coating Equipment Co., Ltd.) under a nitrogen atmosphere for 24 hours (hrs) at a temperature of 60°C. The mixture was then allowed to cool to yield a light yellow and clear viscous liquid (with a solid content of 40%). The viscous liquid was directly used without further treatment.

Araldite MT35600 (Huntsman, The Woodlands, TX) was obtained as a solid resin and before use was dissolved in sufficient methyl ethyl ketone solvent to obtain a 30% solids solution.

The solids weight ratio of acrylic resin/benzoxazine resin was 60/40. The materials listed in Table 4 were mixed for about 10 minutes using a small Cowles-type mixer and the resulting mixture was allowed to stand for 20 minutes to eliminate air bubbles.

The adhesive was coated onto the dull surface of the copper foil using a laboratory handspread apparatus. The coated copper foil was placed in an oven set at 60°C for 10 minutes to form a metal tape having a dry adhesive layer that was about 9-10 microns thick. A release liner having a thickness of about 1 mil (25 micron) (obtained under the trade name "T-50", from Eastman Chemical Co., Martinsville, VA) was laminated at about 60°C to the adhesive layer. The tape was then slit into 1.5 mm wide strips using a small, manually-operated rotary die slitter (Wilson Manufacturing, St. Louis, MO).

**Table 4: 60/40 ratio of acrylic/benzoxazine resins.**

| **Ingredient** | **wt.%** |
|---|---|
| Acrylic resin, 40% solution in 97/3 ethyl acetate/isopropanol | 45 |
| Araldite MT35600, 30% solution in MEK | 40 |
| MEK | 15 |

### Comparative Example 3

The same procedure was used as described in Example 3, with the exception that the material amounts listed in Table 5 were used, resulting in an adhesive with a 70/30 ratio of acrylic resin/benzoxazine resin. Furthermore, the dried adhesive thickness of the metal tape was about 8-10 microns, and the 1.5 mm busbar tape was manually slit using an X-Acto knife.

**Table 5: 70/30 ratio of acrylic resin/benzoxazine.**

| **Ingredient** | **wt.%** |
|---|---|
| Acrylic resin, 40% solution in 97/3 ethyl acetate/isopropanol | 57.1 |
| Araldite MT35600, 40% solution in MEK | 24.5 |
| MEK | 18.4 |

### Module 1

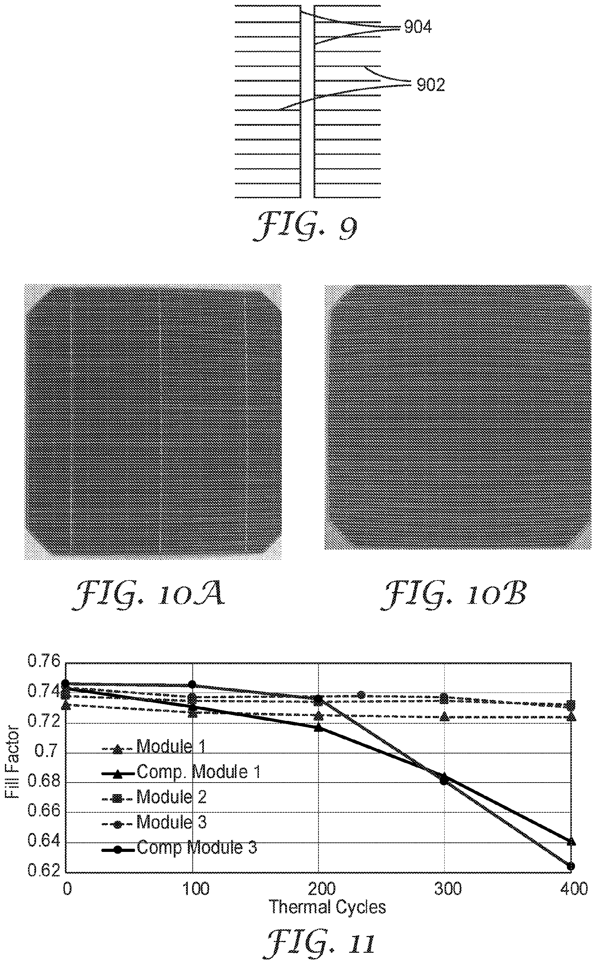

Crystalline silicon solar cells (about 4.5 watts) with three 70 micron wide silver paste busbars on the front of the cell (see Figure 10A) and having no silver tabs on the cell backside (i.e. a full aluminum paste backside) were provided (xSi Solar, Chattanooga, TN). Three strips of backside busbar tape (3mm width, 135 mm long) were prepared as described in Example 4 of U.S. Patent Publication US 2016/0056307. These backside busbar tapes were first bonded to the full aluminum backside as described in paragraph [0086] of U.S. Patent Publication US 2016/0056307 with the following changes: the busbar tape strips were bonded to the solar cell with a hot bar bonder built by Komax Solar (now Xcell Automation, York, PA), and a sheet of silicone rubber interposer (Sarcon 20T-130W purchased from Fujipoly America Corp., Carteret, NJ) was placed between the busbar tape and the metal hot bar element. The bonding time was about 13 seconds. The temperature of the bonding thermode was 300°C, and the temperature of the heated surface below the solar cell during bonding was 100°C. The bond line temperature reached 195-200°C during the 13 second bonding process.

Next, three 153 mm strips of 1.5 mm wide front busbar tape prepared as described in Example 1 were placed directly over each of three 70 micron wide busbars on the cell frontside. The busbar tape strips were then bonded using the same hot bar bonding apparatus and the same procedure as described above for the backside busbar tape.

Using two solar cells bonded with frontside busbar tape, a two-cell solar test module was constructed. The two solar cells were electrically connected in series by manually soldering tabbing ribbon (Ulbrich Solar Technologies, part# WCD102-7746-0381, 62% tin/36% lead/2% silver, 0.15mm x 1.5mm) to the bonded busbar tape on the frontside and the backside of the solar cell. The tabbing ribbon was soldered to a cross bus on each side of the two-cell string. An electrical lead was soldered to each cross bus. The two-cell string was laminated into a 2-cell module using a laminator (model "LM-50x50-S" purchased from NPC, Tokyo, Japan) and the following materials: 7.25 in (18.4 cm) by 14 in (35.5 cm) piece of 1/8 in (0.3 cm) thick solar Solite Solar Glass (manufactured by AFG Industries, Kingsport, TN), "3M Solar Encapsulant Film EVA9100", and 3M Scotchshield Film SF950 backsheet (both available from 3M Company, St. Paul, MN). The lamination conditions were as follows: 4 minute pump down at 150°C (with the pins up), followed by a 12 minute press at 150°C.

### Comparative Module 1

Crystalline silicon solar cells (about 4.45 watts) with no front silver busbars (only gridlines, see Figure 10B) and having no silver tabs on the cell backside (i.e. a full aluminum paste backside) were provided (xSi Solar, Chattanooga, TN). Three strips of backside busbar tape (3mm width, 135 mm long) were first bonded to the full aluminum backside as described previously for Module 1. Next, the 153 mm long and 1.5 mm wide busbar tape prepared in Comparative Example 1 was bonded to the frontside of the solar cell using the same bonding procedure as described for Module 1. Comparative Module 1 was then constructed using the same procedure and materials as described for Module 1 with the exception that 2.0 mm x 0.1 mm stringing ribbon (Indium, product no. RITB-123513-4540, 62% Sn, 36% Pb, 2% Ag) was used.

### Module 2

Crystalline silicon solar cells (about 4.5 watts) with three 70 micron wide silver paste busbars on the front of the cell (see Figure 10A) as well as segmented silver tabs on the cell backside were provided (xSi Solar, Chattanooga, TN). Busbar tape (1.5mm wide) prepared in Example 2 was bonded to the frontside of the solar cell using the same procedure as described for Module 1. Using two solar cells bonded with front side busbar tape, a two-cell solar test module was constructed. The two solar cells were electrically connected in series by manually soldering tabbing ribbon (Ulbrich Solar Technologies, part# WCD102-7746-0381, 62% tin/36% lead/2% silver, 0.15mm x 1.5mm) to the segmented silver busbars on the backside of the solar cell and to the bonded busbar tape on the frontside of the solar cell. A two-cell test module was then prepared using the same procedure given for Module 1.

### Module 3

The same materials and procedure was used as is described for Module 2 with the following changes; the 153 mm long and 1.5 mm wide busbar tape described in Example 3 was applied with the cell placed on a surface heated to about 50-60°C.

### Comparative Module 3

The same solar cells and the same procedure described for Comparative Module 1 was utilized for Comparative Module 3, with the exception that 153 mm long and 1.5 mm wide busbar tape prepared in Comparative Example 3 was bonded to the frontside of the cell, and the busbar tape was applied with the cell placed on a surface heated to about 50-60°C.

Replicate modules of Module 1, Module 2, Module 3, Comparative Module 1 and Comparative Module 3 were subjected to thermal cycle testing. The two-cell test modules were initially tested with the photovoltaic tester as described in Photovoltaic Module Testing, and the two-cell test modules were then placed in the environmental chambers for 400 thermal cycles as described in Aging Tests. The test modules were periodically removed from the environmental chamber and tested with the photovoltaic tester. The 2-cell module fill factor data from thermal cycle testing is provided in Table 6 and Figure 11.

**Table 6: Two-Cell Test Modules - Fill Factor Data from Thermal Cycle Testing.**

| **Thermal Cycles** | **Module 1 ¹** | **Comparative Module 1 ¹** | **Module 2²** | **Module 3 ¹** | **Comparative Module 3 ¹** |
|---|---|---|---|---|---|
| 0 | 0.732 | 0.743 | 0.738 | 0.744 | 0.746 |
| 100 | 0.727 | 0.731 | 0.735 | 0.737 | 0.745 |
| 200 | 0.725 | 0.717 | 0.734 | 0.738 ³ | 0.736 |
| 300 | 0.724 | 0.684 | 0.735 | 0.737 | 0.681 |
| 400 | 0.724 | 0.641 | 0.732 | 0.730 | 0.624 |

| | | | | | |
|---|---|---|---|---|---|
| ¹ Average fill factor data from three two-cell modules in thermal cycle testing ² Average fill factor data from two two-cell modules in thermal cycle testing ³ Average fill factor value after 234 thermal cycles | | | | | |

Modules 1, 2 and 3 were constructed using solar cells with frontside busbar tape bonded to a narrow (70 micron wide) front silver busbar, and these three test modules gave very good performance in thermal cycle testing. Comparative Module 1 and Comparative Module 3 were constructed using solar cells with frontside busbar tape that was bonded only to the front gridlines (i.e. no narrow front silver busbar), and both of these test modules gave unacceptable thermal cycle test performance. Figure 11 clearly shows the positive effect of bonding frontside busbar tape to a narrow front busbar.

It is noted that Modules 2 and 3 were constructed with solar cells having silver tabs on the backside of the solar cells, whereas all the other test modules were constructed with cells having backside busbar tape bonded to the backside of the cell. However, we have shown that solar cells with backside busbar tape are very stable and give outstanding performance in thermal cycle testing. Consequently, the significant difference in thermal cycle test performance between Modules 1, 2, and 3 and Comparative Modules 1 and 3 is due to the presence of a narrow front busbar in Modules 1, 2, and 3.

It is also noted out that Module 3 (with outstanding thermal cycle teste performance) utilized a frontside busbar tape adhesive with a 60/40 ratio of the two resin components, whereas Comparative Module 3 (with poor thermal cycle test performance) utilized a frontside busbar tape adhesive with a 70/30 ratio of the two resin components. Experiments have been done on two-cell test modules made from cells having no narrow front busbar which were bonded with frontside busbar tape coated with a 60/40 ratio of resins, and these test modules performed very poorly in thermal cycle testing. Again, the reason for the significant difference in thermal cycle test performance between Module 3 and Comparative Module 3 is due to that fact that Module 3 was made using cells with a narrow front busbar, whereas Comparative Module 3 was made from cells with no frontside busbar (gridlines only).

### Adhesive Squeeze out

When busbar tape is bonded over a 70 micron wide front busbar on a solar cell using the bonding procedure described for Module 1, the adhesive may be pushed out each side of the busbar tape and flood onto the area of the cell adjacent to the busbar tape. This phenomena is referred to as "adhesive squeeze out" and is an undesirable property. These Examples demonstrate that adhesive squeeze out can be essentially eliminated by using the proper choice of adhesive chemistry and formulation. Figures 12A, 12B, 12C, and 12D show that the adhesive squeeze out of frontside busbar tape bonded over a 70 micron wide busbar on the frontside of a solar cell (obtained from xSi Solar, , Chattanooga, TN) using busbar tape prepared in Example 1, Comparative Example 1, Example 2 and Example 3, respectively. The same front busbar tape bonding procedure was used as is described for Module 1. These four bonded cells are referred to as Test Cell 1, Comparative Test Cell 1, Test Cell 2 and Test Cell 3, respectively. One can see that the busbar tape adhesive described in Example 2 (Test Cell 2, Figure 12C) and Example 3 (Test Cell 3, Figure 12D) gave significantly less adhesive squeeze out than the busbar tape adhesive described in Example 1 (Test Cell 1, Figure 12A) and Comparative Example 1 (Comparative Test Cell 1, Figure 12B). The adhesive squeeze out results are summarized in Table 7.

### 180° peel adhesion

Stringing ribbon (the same ribbon used for preparing Module 1) was soldered to Test Cell 1, Comparative Test Cell 1, Test Cell 2 and Test Cell 3. The stringing ribbon was soldered to the bonded front busbar tape on all the test cells, and about 2 inches of unsoldered ribbon extended beyond the test cell to facilitate 180° peel testing. Using the same solar cell with a 70 micron front busbar and the same stringing ribbon as previously described, stringing ribbon was soldered directly to the 70 micron front busbar (i.e. no busbar tape was bonded to the narrow front busbar), and this soldered test cell is referred to as "Direct Solder Test Cell". The test cells with soldered stringing ribbon were mounted on an Imass SP-2100 peel tester (Instrumentors, Inc., Strongsville, OH), and the 180° peel force was measured as the soldered stringing ribbon was peeled from the cell at a rate of 12 inches/min. The average peel force over a 5 second test interval was recorded, and the average peel force from several tests is recorded in Table 7. It is noted that the industry minimum standard for 180° peel is about 300 grams of force when using a 1.5 mm wide stringing ribbon (i.e. 2 N/mm), and only Test Cell 2 in Table 7 meets this industry requirement.

**Table 7: 180° Peel and Adhesive Squeeze Out.**

| **Test Sample** | **Description** | **Ave. 180° Peel Force (grams)** | **Adhesive Squeeze Out** |
|---|---|---|---|
| Test Cell 1 | 10 micron thick epoxy adhesive | 227 gram ³ (std dev 50.6) | Not Acceptable |
| Comparative Test Cell 1 | 5 micron thick epoxy adhesive | 198 grams ¹ (std dev 44.2) | Not Acceptable |
| Test Cell 2 | 6-7 micron thick epoxy adhesive with fumed silica | 317.6 grams ¹ (std dev 64.5) | Acceptable |
| Test Cell 3 | 10 micron thick adhesive comprising 60/40 acrylic/benzoxazine adhesive | 246 grams ² (std dev 34.2) | Acceptable |
| Direct Solder Test Cell | Stringing ribbon soldered directly to 70 micron front busbar | 36 grams ³ (std dev 14.2) | n/a |

### Discussion

As can be seen from the results above, frontside busbar tapes bonded to a solar cell with a narrow frontside busbars have acceptable performance in thermal cycle testing. The positive effect of bonding frontside busbar tape to a solar cell with a narrow front busbar is clearly displayed in Figure 11, which shows that the fill factor for Comparative Module 1 and Comparative Module 3 decrease significantly after 200 thermal cycles, while Modules 1, 2, and 3 maintain consistent fill factors even after 400 thermal cycles. Furthermore, when considering both 180° peel and adhesive squeeze out, frontside busbar tape prepared in Example 2 (and corresponding Test Cell 2 and Module 2) shows superior performance. However, as can be seen from Table 7, other test cells also had acceptable peel force (Test Cells 1 and 3) and are considered suitable embodiments of this disclosure, even if adhesive squeeze out was less than desirable for Test Cell 1.

### Dual Narrow Busbar Prophetic Example

### Screen-printing blue cells

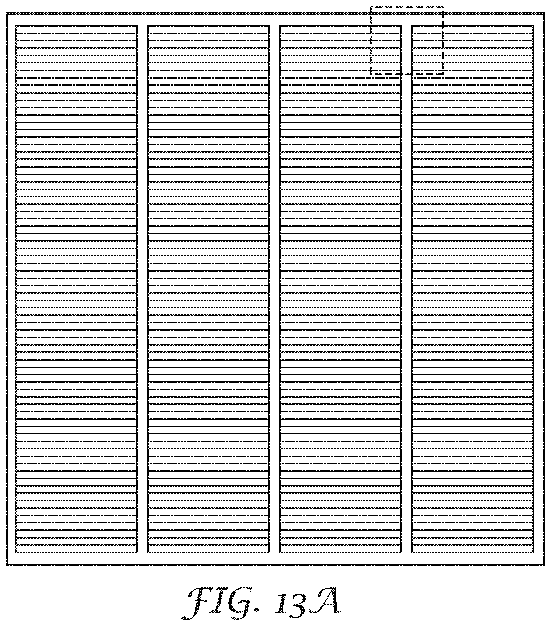

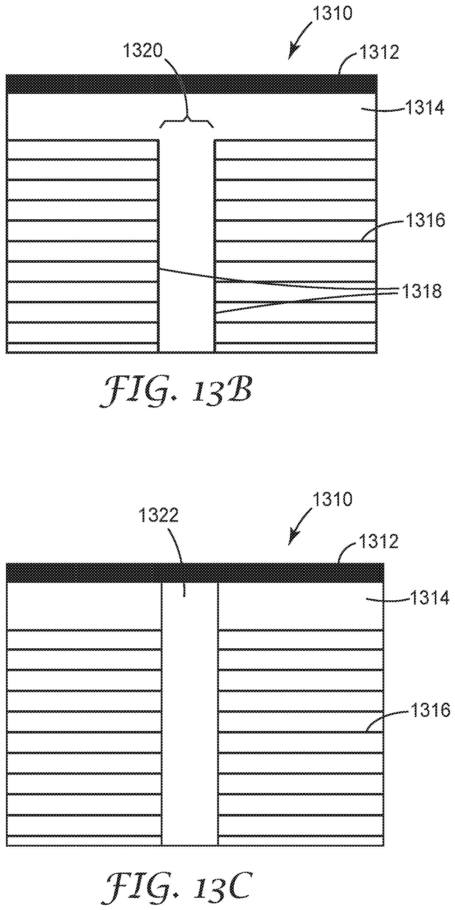

Crystalline silicon solar cells (about 4.45 watts) with no front silver busbars or gridlines and having no silver tabs or aluminum on the cell backside (i.e., blue cells) may be obtained from Motech Solar, a division of Motech Industries, Inc. (Taiwan). The frontside of each solar cell is screen-printed with Heraeus 9620A silver paste (Hanau, Germany) in the pattern shown in Figures 13A and 13B. In this pattern, the busbars and the gridlines are about 70 microns wide, the gap between gridlines is about 2 mm, and the gap between adjacent busbars is about 1.5 mm, measuring from center-to-center of the busbars. After printing, the solar cells are placed in a 100°C oven to dry the paste. The backside is then screen-printed with 473W aluminum paste (Sun Chemical, Parsippany, NJ) over all or most of the backside surface and the solar cells are returned to the oven to dry the paste. Optionally, portions of the backside of each solar cell may be printed with silver paste and dried in the oven prior to the application of aluminum paste. The solar cells are then placed in a furnace at approximately 800°C to fire the metal pastes.

### Frontside busbar tape

A solvent-based epoxy thermoset adhesive is prepared using the materials listed in Table 8, wherein the amount of each ingredient is expressed as weight percent based on the total adhesive weight. The Epon SU-2.5 epoxy resin is heated to 60°C prior to compounding. The charge 1 materials are combined and manually mixed until a homogenous mixture resulted. The charge 2 material (epoxy resin curative) is then added and mixed manually until the material was homogeneous. Next, the charge 3 ingredients are added. The fumed silica in charge 3 is added in nine increments with extensive manual mixing after each addition, and solvent is also added in three incremental portions with extensive manual mixing. After the charge 4 solvent is added, a thick, creamy material results. The mixture is then mixed with a high speed Cowles-type mixer. After extensive mixing, the charge 5 solvent is added which reduces the percent solids to about 40%. The mixture is then filtered through a 100 micron filter. The adhesive mixture is further filtered through a second 100 micron filter and then coated onto the primed side (dull side) of a 21.25 inch wide and 12 micron thick copper foil ("TOB-III" from OakMitsui, Camden, SC). The line speed of the coating process is 60 ft/min. The adhesive layer is dried in a series of drying ovens set, respectively, at 130°F, 150°F, and 170°F. The adhesive layer is subsequently sent through two standard 25-foot-long drying ovens set at 170°F. The dried adhesive layer has a thickness of about 6-7 microns. The release liner (25 micron thick, available under the trade name "T-50", from Eastman Chemical Co., Martinsville, VA) is laminated over the adhesive layer. The stockroll of busbar tape is stage slit down to a width of 104 mm, followed by shear slitting down to a width of 1.5 mm.

**Table 8: Epoxy adhesive with Fumed Silica.**

| **Charge** | **Ingredient** | **wt.%** |
|---|---|---|
| 1 | Epoxy Resin | 29.9 |
| 1 | 40% Phenoxy resin in methyl ethyl ketone | 10.0 |
| 1 | MEK (first charge) | 3.3 |
| 2 | Epoxy Resin Curative | 2.1 |
| 3 | MEK (second charge) | 4.8 |
| 3 | Fumed Silica | 4.0 |
| 4 | MEK | 22.0 |
| 5 | MEK | 23.9 |

### Bonding frontside busbar tape to solar cell

This frontside busbar tape is applied to the frontside of the solar cells in the gap between each pair of adjacent busbars and in electrical contact with both of the busbars, as shown in Figure 13C. The frontside busbar tape may be narrower than the center-to-center distance between the busbars, but must be wide enough to provide electrical contact with both busbars. The busbar tape strips are bonded to the solar cell with a hot bar bonder built by Komax Solar (now Xcell Automation, York, PA), and a sheet of silicone rubber interposer (Sarcon 20T-130W, available from Fujipoly America Corp., Carteret, NJ) is placed between the busbar tape and the metal hot bar element. The bonding time is about 13 seconds. The temperature of the bonding thermode is 300°C, and the temperature of the heated surface below the solar cell during bonding is 100°C. The bond line temperature reaches 195-200°C during the 13 second bonding process.

### Backside busbar tape

To produce an embossed metal backside tape, copper foil having a thickness of 12 microns (available under the trade designation "TOB-III", from OakMitsui, Camden, SC) is provided. The copper foil has a first surface and a second surface, the first surface being dull. A solvent-based epoxy thermoset adhesive is prepared using the ingredients listed in Table 9, wherein the amount of each ingredient is expressed as weight percent based on the total adhesive weight. The ingredients are mixed in the order listed in Table 9, except for the second charge of MEK, which is added as described below. The mixture is mixed aggressively with a Cowles-type mixer for 1 hour. The second charge of MEK is then added slowly with mixing, and the resulting mixture is gently mixed for 5 minutes. The mixture is subsequently filtered through a 100 micron filter.

**Table 9: Composition of Solvent Based Epoxy Thermoset Adhesive of Example 4**

| **Ingredient** | **Trade designation** | **Supplier** | **Weight percent** |
|---|---|---|---|
| Epoxy resin | EPON SU-2.5 | Momentive (Columbus, OH) | 29.91 |
| 40% Phenoxy resin in methyl ethyl ketone | PKHS-40 | InChem Corporation (Rock Hill, SC) | 10.00 |
| Core-shell particles | PARALOID EXL-2330 | Dow Chemical (Midland, MI) | 4.00 |
| Epoxy curative | 2MZ-AZINE (fine grind) | Air Products (Allentown, PA) | 2.09 |
| Solvent | Methyl ethyl ketone (MEK) (first charge) | Brenntag Great Lakes (Reading, PA) | 6.64 |
| Solvent | MEK (second charge) | Brenntag Great Lakes (Reading, PA) | 47.36 |

The adhesive is further filtered through a 30 micron filter and then coated onto the primed side of the 17 in wide and 12 micron thick copper foil (Oak Mitsui TOB-III). The line speed of the coating process is 60 ft/min. The adhesive layer is dried in a series of drying ovens set, respectively, at 130°F (54°C), 150°F (65°C), and 170°F (77°C). The adhesive layer is subsequently passed through two standard 25 ft (7.6 m) long drying ovens set at 170°F. The dried adhesive layer has a thickness of 20 microns. A release liner having a thickness of about one mil (25 micron) (available under the trade name "T-50" from Eastman Chemical Co., Martinsville, Va.) is laminated to the adhesive layer, and the 17 in (43 cm) wide metal tape is slit into two 8 in (20 cm) wide rolls.

The 8 in wide metal tape is embossed by passing it through a roll-to-roll embossing apparatus. One of the embossing rolls has a metallic dot pattern comprising protrusions arranged in a trapezoidal configuration at a density of 41 protrusions per square centimeter, and each protrusion has a height of about 0.39 mm, and diameters of about 0.74 mm at the base and about 0.43 mm at the top. The other roll is compliant. The 8" wide metal tape rolls are embossed using an embossing force of 700 lbf, and a line speed of 20 ft/min (6 m/min). In addition, an unwind tension of 1 lbf (0.45 kgf) and a wind tension of 20 lbf (54 kgf) are applied. The embossed metal backside tape is then slit into 3 mm wide rolls.

### Bonding backside busbar tape to solar cell

The release liner is removed from three strips of the embossed metal backside tape, which are then applied to the aluminum backside of the prepared crystalline silicon solar cells. The crystalline silicon solar cells contain no silver paste busbars on the aluminum backside, and are also referred to as full-aluminum back plane cells. The three strips of metal tape are 132 mm in length and placed so that their relative location corresponds to the location of dual narrow busbars disposed on the frontside of the solar cell. The metal tape strips are then bonded to the solar cell using the hot bar bonder and procedure described above in Bonding frontside busbar tape to solar cell.

### Lamination of test module

Using two solar cells bonded with frontside busbar tape and backside busbar tape, a two-cell solar test module is constructed. The two solar cells are electrically connected in series by manually soldering tabbing ribbon (Ulbrich Solar Technologies, part# WCD102-7746-0381, 62% tin/36% lead/2% silver, 0.15mm x 1.5mm) to the embossed metal busbar tapes on the backside of the solar cell and to the bonded busbar tape on the frontside of the solar cell. The tabbing ribbon is soldered to a cross bus on each side of the two-cell string. An electrical lead is soldered to each cross bus. The two-cell string is laminated into a 2-cell module using a laminator (model "LM-50x50-S" purchased from NPC, Tokyo, Japan) and the following materials: 7.25 in (18.4 cm) by 14 in (35.5 cm) piece of 1/8 in (0.3 cm) thick solar Solite Solar Glass (manufactured by AFG Industries, Kingsport, TN), "3M Solar Encapsulant Film EVA9100", and 3M Scotchshield Film SF950 backsheet (both available from 3M Company, St. Paul, MN). The lamination conditions are as follows: 4 minute pump down at 150°C (with the pins up), followed by a 12 minute press at 150°C.

## Claims

1. A photovoltaic cell comprising:
a photoactive surface (810),
a continuous busbar (802) in contact with the photoactive surface,
a busbar tape (804) in electrical contact with the continuous busbar,
a stringing ribbon (814) soldered to the busbar tape, the busbar tape comprising a conductive metal foil (806) and a nonconductive thermoset adhesive (808),
wherein the continuous busbar has a width from 50 microns to 90 microns,
wherein at least a portion of the busbar tape is adhered to the photoactive surface and the continuous busbar via the nonconductive thermoset adhesive, and
wherein the busbar tape is solderable.

2. The photovoltaic cell of claim 1, wherein the photovoltaic cell further comprises a plurality of gridlines intersecting the busbar, wherein the gridlines are in electrical contact with the busbar, and wherein the busbar tape is further adhered to the gridlines via the nonconductive thermoset adhesive.

3. The photovoltaic cell of claim 1, wherein the photovoltaic cell further comprises a plurality of gridlines intersecting the busbar in a direction substantially perpendicular to the busbar, wherein the gridlines are in electrical contact with the busbar, and wherein the busbar tape is further adhered to the gridlines via the nonconductive thermoset adhesive.

4. The photovoltaic cell of claim 1, wherein the busbar comprises fired silver paste.

5. The photovoltaic cell of claim 1, wherein the busbar has a width from 60 to 80 microns.

6. The photovoltaic cell of claim 1, wherein the metal foil comprises copper.

7. The photovoltaic cell of claim 1, wherein the metal foil comprises zinc.

8. The photovoltaic cell of claim 1, wherein the busbar tape is embossed.

9. The photovoltaic cell of claim , wherein the busbar tape is able to conform to one or
more of the gridlines.

10. The photovoltaic cell of claim 1, wherein the nonconductive adhesive comprises at least one of epoxy resins, acrylic resins, polyurethanes, polyesters, polyimides, polyamides, cyanate esters, phenolic resins, maleimide resins, phenoxy resins, benzoxazine resins, and mixtures thereof.

11. The photovoltaic cell of claim 1, wherein the nonconductive adhesive comprises fumed silica particles.

12. The photovoltaic cell of claim 1, wherein the nonconductive adhesive comprises an epoxy resin, a phenoxy resin, and fumed silica particles.

## Patentansprüche

1. Fotovoltaikzelle, umfassend:
eine fotoaktive Oberfläche (810),
eine durchgehende Sammelschiene (802) in Kontakt mit der fotoaktiven Oberfläche,
ein Sammelschienenband (804)
in elektrischem Kontakt mit der durchgehenden Sammelschiene,
eine Aneinanderreihungsborte (814),
die mit dem Sammelschienenband verlötet wird, wobei das Sammelschienenband eine leitfähige Metallfolie (806) und einen nicht leitfähigen wärmehärtenden Kleber (808) umfasst,
wobei die durchgehende Sammelschiene eine Breite von 50 Mikrometer bis 90 Mikrometer aufweist,
wobei zumindest ein Abschnitt des Sammelschienenbandes über den nicht leitfähigen wärmehärtenden Kleber mit der fotoaktiven Oberfläche und der durchgehenden Sammelschiene verklebt wird, und
wobei das Sammelschienenband lötbar ist.

2. Fotovoltaikzelle nach Anspruch 1, wobei die Fotovoltaikzelle ferner eine Mehrzahl von Gitterlinien umfasst, die die Sammelschiene kreuzen, wobei die Gitterlinien in elektrischem Kontakt mit der Sammelschiene stehen und wobei das Sammelschienenband ferner über den nicht leitfähigen wärmehärtenden Kleber mit den Gitterlinien verklebt wird.

3. Fotovoltaikzelle nach Anspruch 1, wobei die Fotovoltaikzelle ferner eine Mehrzahl von Gitterlinien umfasst, die die Sammelschiene in einer Richtung im Wesentlichen senkrecht zur Sammelschiene kreuzen, wobei die Gitterlinien in elektrischem Kontakt mit der Sammelschiene stehen und wobei das Sammelschienenband ferner über den nicht leitfähigen wärmehärtenden Kleber mit den Gitterlinien verklebt wird.

4. Fotovoltaikzelle nach Anspruch 1, wobei die Sammelschiene gebrannte Silberpaste umfasst.

5. Fotovoltaikzelle nach Anspruch 1, wobei die Sammelschiene eine Breite von 60 bis 80 Mikrometer aufweist.

6. Fotovoltaikzelle nach Anspruch 1, wobei die Metallfolie Kupfer umfasst.

7. Fotovoltaikzelle nach Anspruch 1, wobei die Metallfolie Zink umfasst.

8. Fotovoltaikzelle nach Anspruch 1, wobei das Sammelschienenband geprägt ist.

9. Fotovoltaikzelle nach Anspruch 2, wobei das Sammelschienenband in der Lage ist, sich einer oder
mehrerer der Gitterlinien anzugleichen.

10. Fotovoltaikzelle nach Anspruch 1, wobei der nicht leitfähige Kleber mindestens eines von Epoxidharzen, Acrylharzen, Polyurethanen, Polyestern, Polyimiden, Polyamiden, Cyanatestern, Phenolharzen, Maleimidharzen, Phenoxyharzen, Benzoxazinharzen und Mischungen davon umfasst.

11. Fotovoltaikzelle nach Anspruch 1, wobei der nicht leitfähige Kleber pyrogene Siliciumdioxidteilchen umfasst.

12. Fotovoltaikzelle nach Anspruch 1, wobei der nicht leitfähige Kleber ein Epoxidharz, ein Phenoxyharz und pyrogene Siliciumdioxidteilchen umfasst.

## Revendications

1. Cellule photovoltaïque comprenant :
une surface photoactive (810),
une barre omnibus continue (802) en contact avec la surface photoactive,
un ruban de barre omnibus (804) en contact électrique avec la barre omnibus continue,
un ruban de déroulage (814) soudé au ruban de barre omnibus, le ruban de barre omnibus comprenant une feuille métallique conductrice (806) et un adhésif thermodurcissable non conducteur (808),
dans laquelle la barre omnibus continue a une largeur allant de 50 micromètres à 90 micromètres,
dans laquelle au moins une partie du ruban de barre omnibus est fixé par adhérence à la surface photoactive et à la barre omnibus continue par l'intermédiaire de l'adhésif thermodurcissable non conducteur, et
dans laquelle le ruban de barre omnibus peut être soudé.

2. Cellule photovoltaïque selon la revendication 1, dans laquelle la cellule photovoltaïque comprend en outre une pluralité de quadrillage croisant la barre omnibus, dans laquelle les quadrillages sont en contact électrique avec la barre omnibus, et dans laquelle le ruban de barre omnibus est en outre fixé par adhérence aux quadrillages par l'intermédiaire de l'adhésif thermodurcissable non conducteur.

3. Cellule photovoltaïque selon la revendication 1, dans laquelle la cellule photovoltaïque comprend en outre une pluralité de quadrillages croisant la barre omnibus dans une direction essentiellement perpendiculaire à la barre omnibus, dans laquelle les quadrillages sont en contact électrique avec la barre omnibus, et dans laquelle le ruban de barre omnibus est en outre fixé par adhérence aux quadrillages par l'intermédiaire de l'adhésif thermodurcissable non conducteur.

4. Cellule photovoltaïque selon la revendication 1, dans laquelle la barre omnibus comprend de la pâte d'argent cuite.

5. Cellule photovoltaïque selon la revendication 1, dans laquelle la barre omnibus a une largeur allant de 60 à 80 micromètres.

6. Cellule photovoltaïque selon la revendication 1, dans laquelle la feuille métallique comprend du cuivre.

7. Cellule photovoltaïque selon la revendication 1, dans laquelle la feuille métallique comprend du zinc.

8. Cellule photovoltaïque selon la revendication 1, dans laquelle le ruban de barre omnibus est gaufré.

9. Cellule photovoltaïque selon la revendication 2, dans laquelle le ruban de barre omnibus est capable d'épouser la forme d'un ou plusieurs des quadrillages.

10. Cellule photovoltaïque selon la revendication 1, dans laquelle l'adhésif non conducteur comprend au moins l'un parmi des résines époxy, des résines acryliques, des polyuréthanes, des polyesters, des polyimides, des polyamides, des esters de cyanate, des résines phénoliques, des résines maléimide, des résines phénoxy, des résines benzoxazine et des mélanges de ceux-ci.

11. Cellule photovoltaïque selon la revendication 1, dans laquelle l'adhésif non conducteur comprend des particules de silice fumée.

12. Cellule photovoltaïque selon la revendication 1, dans laquelle l'adhésif non conducteur comprend une résine époxy, une résine phénoxy et des particules de silice fumée.
